# EUROPEAN PATENT SPECIFICATION

(11) **EP 3 879 949 B1**
(45) Date of publication and mention of the grant of the patent: **25.10.2023**
(21) Application number: 19898423.9
(22) Date of filing: 17.12.2019
(51) Int. Cl.: H05K 7/20

(54) **MACHINE CABINET**
MASCHINENGEHÄUSE
ARMOIRE DE MACHINE

(30) Priority: 21.12.2018 CN 201811573370
(43) Date of publication of application: 15.09.2021
(73) Proprietor: Huawei Digital Power Technologies Co., Ltd., Shenzhen, 518043 (CN)
(72) Inventor: LIAN, Zhisheng, Shenzhen, Guangdong 518129 (CN); CHEN, Jun, Shenzhen, Guangdong 518129 (CN); LI, Quanming, Shenzhen, Guangdong 518129 (CN); WANG, Xingjie, Shenzhen, Guangdong 518129 (CN)
(74) Representative: Epping - Hermann - Fischer
(86) International application number: PCT/CN2019/125823
(87) International publication number: WO 2020/125599

(56) References cited:
- WO-A1-2012/077374
- US-A1- 2006 032 609

## Description

### TECHNICAL FIELD

This application relates to the cabinet field, and in particular, to a cabinet whose heat dissipation capability can be expanded.

### BACKGROUND

An outdoor cabinet is a cabinet installed outdoors. Common outdoor cabinets include, for example, an outdoor power supply cabinet and an outdoor equipment cabinet. To ensure that a temperature of a device inside the outdoor cabinet does not become excessively high easily, the outdoor power supply cabinet and the outdoor equipment cabinet have independent heat dissipation systems. The heat dissipation system is used to perform heat dissipation on devices in the cabinets, to avoid a case in which temperatures of the devices in the cabinets become excessively high, and consequently working performance is affected.

Currently, there are usually two heat dissipation manners for the outdoor cabinet: a door-mounted temperature control manner and a top-mounted temperature control manner. The door-mounted temperature control manner is specifically that a temperature control component is disposed on a cabinet door of the cabinet, and does not occupy space in the cabinet, so that utilization of the cabinet is relatively high. Maintenance can be performed by only opening the door The top-mounted temperature control manner is specifically that a temperature control component is disposed at a top of the cabinet, and also does not occupy space in the cabinet. The temperature control component is an independent component that can actively control a temperature in the cabinet. A commonly used temperature control component is a heat exchanger, an air conditioner, or a semiconductor refrigeration air conditioner (Thermoelectric Cooler, TEC for short).

However, in the foregoing two temperature control manners, once a heat dissipation capability of the cabinet is insufficient, an original temperature control component can only be removed to free space for replacement with a temperature control component with a larger size and a stronger capability. However, in this case, the temperature control component is wasted. In addition, due to a limitation on a size of the cabinet, a temperature control capability is limited to an extent, and an upgrade requirement of the heat dissipation capability of the cabinet cannot be met. WO2012077374A1 relates to an electrical-equipment panel that is equipped with a cabinet comprising a cabinet-section duct, a roof comprising a roof-section duct, and a heat radiating equipment installed within the cabinet. The electrical-equipment panel has, installed within the cabinet-section duct, heat radiation fins for the heat radiating equipment, and a fan for sucking in air from an air-intake hole of the cabinet-section duct and exhausting the air through an exhaust hole of the cabinet-section duct. The electrical-equipment panel also has, installed within the roof-section duct, a heat exchanger for transmitting heat within an equipment housing section outside, and a fan for sucking in air from an air-intake hole of the roof-section duct and exhausting the air through an exhaust hole of the roof-section duct.

US20060032609A1 relates to an electronics cabinet comprising a bottom surface; a top surface; a plurality of side wall surfaces connected to the bottom surface and the top surface; a door connected to a side wall surface, when the door is closed, the bottom surface, top surface, side wall surfaces, and door form an air tight and water tight enclosure; and a heat exchanger mounted to an exterior surface of the electronics cabinet.

### SUMMARY

The invention is set out in the appended set of claims. In the following, parts of the description and drawings referring to embodiments which are not covered by the claims are not presented as embodiments of the invention, but as examples useful for understanding the invention. This application provides a cabinet, to avoid a waste of a temperature control component, expand a heat dissipation capability of the cabinet, and resolve an existing problem that the temperature control component is wasted and the heat dissipation capability of the cabinet cannot meet an upgrade requirement due to replacement of the temperature control component when the heat dissipation capability of the cabinet is insufficient.

This application provides a cabinet, including a cabinet body. A first-stage temperature control component configured to control a temperature of the cabinet body is disposed on the cabinet body, and at least one temperature control capacity expansion interface that may be used to connect a second-stage temperature control component and the cabinet body is disposed on the cabinet body, so that the second-stage temperature control component is disposed on the cabinet body in an expandable manner.

The cabinet provided in this application includes the cabinet body. The first-stage temperature control component configured to control the temperature of the cabinet body is disposed on the cabinet body, and the at least one temperature control capacity expansion interface that may be used to connect the second-stage temperature control component and the cabinet body is disposed on the cabinet body. In this case, when a heat dissipation capability of the cabinet is insufficient, because the temperature control capacity expansion interface is reserved on the cabinet body, the second-stage temperature control component may further be directly disposed on the cabinet body through the temperature control capacity expansion interface, so that the temperature control component on the cabinet is expanded, and the cabinet is upgraded from one-stage temperature control to two-stage temperature control. Under an action of the first-stage temperature control component and the second-stage temperature control component, the heat dissipation capability of the cabinet is greatly improved. In comparison with the conventional technology, in this application, when the heat dissipation capability of the cabinet is insufficient, the first-stage temperature control component does not need to be replaced, and the second-stage temperature control component is directly disposed on the cabinet body in the expandable manner through the temperature control capacity expansion interface, so that the temperature control component of the cabinet can be expanded, thereby avoiding a conventional-technology problem that an original temperature control component is wasted due to replacement with a temperature control component with a larger size and a stronger heat dissipation capability. In addition, in this application, the second-stage temperature control component may be connected through the reserved temperature control capacity expansion interface, so that a temperature control capability of the cabinet is upgraded from the one-stage temperature control to the two-stage temperature control when a size of the cabinet body remains unchanged, to meet an upgrade requirement of the heat dissipation capability of the cabinet. Therefore, the cabinet provided in this application can expand the temperature control component of the cabinet, meet the upgrade requirement for the heat dissipation capability of the cabinet, and resolve an existing problem that the temperature control component is wasted and the heat dissipation capability of the cabinet cannot meet the upgrade requirement due to replacement of the temperature control component when the heat dissipation capability of the cabinet is insufficient. The second-stage temperature control component and the first-stage temperature control component form a circulating cooling air duct in the cabinet body. The cabinet further includes the second-stage temperature control component. The second-stage temperature control component is disposed on the cabinet body through the temperature control capacity expansion interface.

A first internal circulation air duct and a first external circulation air duct are disposed in the first-stage temperature control component, a second internal circulation air duct and a second external circulation air duct are disposed in the second-stage temperature control component, an air intake vent and an air exhaust vent of the first internal circulation air duct and an air intake vent and an air exhaust vent of the second internal circulation air duct each communicate with internal space in the cabinet body, to form the circulating cooling air duct in the cabinet body, the air exhaust vent of the first internal circulation air duct and the air intake vent of the second internal circulation air duct are disposed opposite to each other, so that cold air obtained after cooling in the first internal circulation air duct enters the second internal circulation air duct for cooling again.

The first-stage temperature control component and the second-stage temperature control component may be heat exchangers or air conditioners.

The first internal circulation air duct and the first external circulation air duct may be separated by a heat exchange element in the first-stage temperature control component, and the second internal circulation air duct and the second external circulation air duct may be separated by a heat exchange element in the second-stage temperature control component.

An internal circulation fan is disposed at each of the air intake vent of the first internal circulation air duct and the air intake vent of the second internal circulation air duct, such that the hot air in the cabinet is sucked into an internal circulation air duct through the air intake vent of the first internal circulation air duct and the air intake vent of the second internal circulation air duct under an action of the internal circulation fan for cooling.

In a possible implementation of the first aspect, an air intake vent and an air exhaust vent of the first external circulation air duct and an air intake vent and an air exhaust vent of the second external circulation air duct each communicate with an exterior of the cabinet body.

In a possible implementation the first internal circulation air duct and the first external circulation air duct are two air ducts whose air flow directions are opposite to each other, and the second internal circulation air duct and the second external circulation air duct are two air ducts whose air flow directions are opposite to each other. In a possible implementation the cabinet body includes a cabinet frame and a cabinet door, the first-stage temperature control component is disposed on the cabinet frame or the cabinet door, and the temperature control capacity expansion interface is disposed on the cabinet frame or the cabinet door.

In a possible implementation the first-stage temperature control component is disposed at a top of the cabinet frame, and the temperature control capacity expansion interface is disposed on the cabinet door, so that the second-stage temperature control component is disposed on the cabinet door in the expandable manner.

In a possible implementation the first-stage temperature control component is disposed on the cabinet door, and the temperature control capacity expansion interface is disposed on a top end face of the cabinet frame, so that the second-stage temperature control component is disposed on the cabinet frame in the expandable manner.

In a possible implementation , the first-stage temperature control component is disposed at the top of the cabinet frame, the second-stage temperature control component is disposed on the cabinet door, the air exhaust vent of the first internal circulation air duct is disposed close to the cabinet door, the air intake vent of the first internal circulation air duct is disposed close to a rear side wall of the cabinet frame, the air intake vent of the second internal circulation air duct is disposed close to the air exhaust vent of the first internal circulation air duct, and the air exhaust vent of the second internal circulation air duct is disposed close to a bottom end of the cabinet door; or
the air exhaust vent and the air intake vent of the first internal circulation air duct are respectively disposed close to two opposite internal side walls in the cabinet frame, the air intake vent of the second internal circulation air duct is disposed close to the air exhaust vent of the first internal circulation air duct, and the air exhaust vent of the second internal circulation air duct is disposed at an end that is of the cabinet door and that is away from the air intake vent of the second internal circulation air duct.

In a possible implementation the first-stage temperature control component is disposed at the top of the cabinet frame, the second-stage temperature control component is disposed on the cabinet door, the air exhaust vent and the air intake vent of the first external circulation air duct are disposed on a side face or a top face of the first-stage temperature control component, and the air intake vent and the air exhaust vent of the second external circulation air duct are disposed on the cabinet door.

In a possible implementation the first-stage temperature control component is disposed at the top of the cabinet frame, the second-stage temperature control component is disposed on the cabinet door, the first external circulation air duct in the first-stage temperature control component has one or more air intake vents, and a plurality of air intake vents of the first external circulation air duct are respectively located on a side face and/or a top face of the first-stage temperature control component.

In a possible implementation an external circulation fan is disposed at each of the air intake vent of the first external circulation air duct and the air intake vent of the second external circulation air duct.

In a possible implementation the cabinet further includes a cover. The cover is configured to cover the temperature control capacity expansion interface when the second-stage temperature control component is not connected to the temperature control capacity expansion interface, so that the temperature control capacity expansion interface is in a closed state.

In a possible implementation , the cabinet is an outdoor cabinet or an indoor cabinet

With reference to the accompanying drawings, these and other aspects, implementations, and advantages of the example embodiments become apparent according to the embodiments described below. However, it should be understood that the specification and the accompanying drawings are only used for illustrative purposes and are not intended to be a limitation on this application. For details, refer to the appended claims. Other aspects and advantages of this application are described in the following descriptions and some are apparent based on the descriptions or are learned of from the practice of this application. In addition, aspects and advantages of this application may be realized and obtained by using a means and a combination specifically noted in the appended claims.

### BRIEF DESCRIPTION OF DRAWINGS

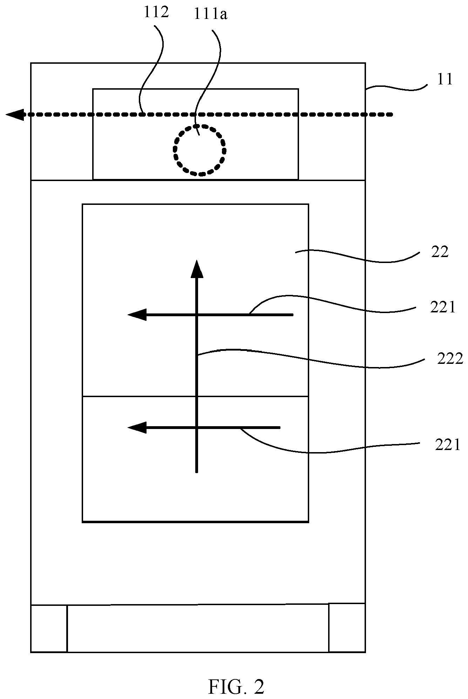

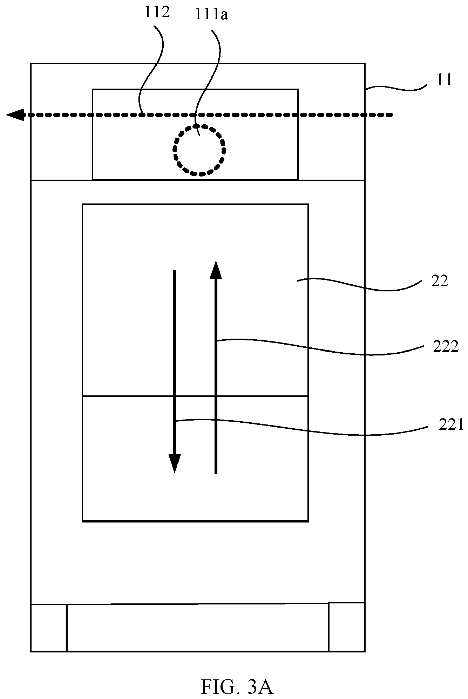

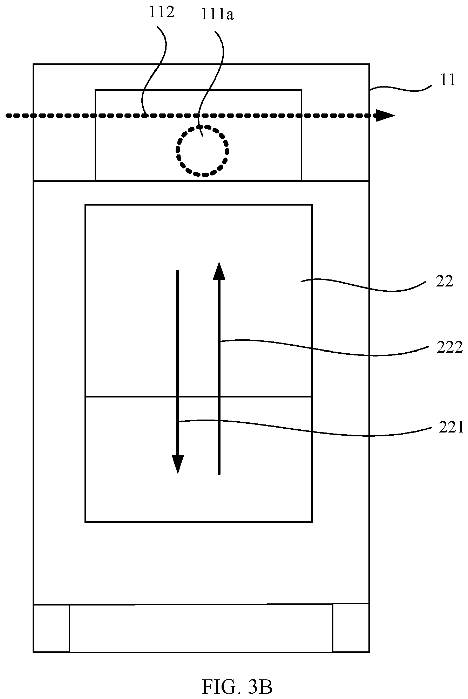

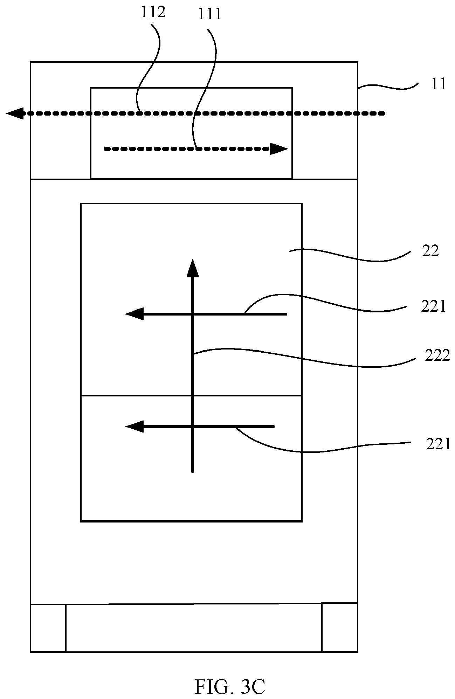

The embodiment 2 and 3 detailed along Figures 2 and 3 are not according to the invention and present for illustrative purpose only.
FIG. 1A is a schematic three-dimensional diagram of a cabinet according to Embodiment 1 of this application;
FIG. 1B is another schematic three-dimensional diagram of a cabinet according to Embodiment 1 of this application;
FIG. 1C is a schematic structural diagram of a side section of a cabinet according to Embodiment 1 of this application;
FIG. 1D is a schematic structural diagram of an air flow direction in an internal circulation air duct and an air flow direction in an external circulation air duct in a temperature control component of a cabinet according to Embodiment 1 of this application;
FIG. 1E is still another schematic structural diagram of a cabinet according to Embodiment 1 of this application;
FIG. 2 is a schematic structural diagram of an air flow direction in an internal circulation air duct and an air flow direction in an external circulation air duct in a temperature control component in a main view of a cabinet according to Embodiment 2 of this application;
FIG. 3A is a schematic structural diagram of an air flow direction in an internal circulation air duct and an air flow direction in an external circulation air duct in a temperature control component in a main view of a cabinet according to Embodiment 3 of this application;
FIG. 3B is another schematic structural diagram of an air flow direction in an internal circulation air duct and an air flow direction in an external circulation air duct in a temperature control component in a main view of a cabinet according to Embodiment 3 of this application; and
FIG. 3C is still another schematic structural diagram of an air flow direction in an internal circulation air duct and an air flow direction in an external circulation air duct in a temperature control component in a main view of a cabinet according to Embodiment 3 of this application.

Description of reference numerals:
10: Cabinet frame;
11: First-stage temperature control component;
111: Flow direction in a first internal circulation air duct;
112: Flow direction in a first external circulation air duct;
101, 101a, and 101b: Air intake vents of a first external circulation air duct;
12: Temperature control capacity expansion interface;
20: Door;
22: Second-stage temperature control component;
201: Air intake vent of a second external circulation air duct;
202: Air exhaust vent of a second external circulation air duct;
221: Flow direction in a second internal circulation air duct;
222: Flow direction in a second external circulation air duct;
31: Internal circulation fan; and
32: External circulation fan.

### DESCRIPTION OF EMBODIMENTS

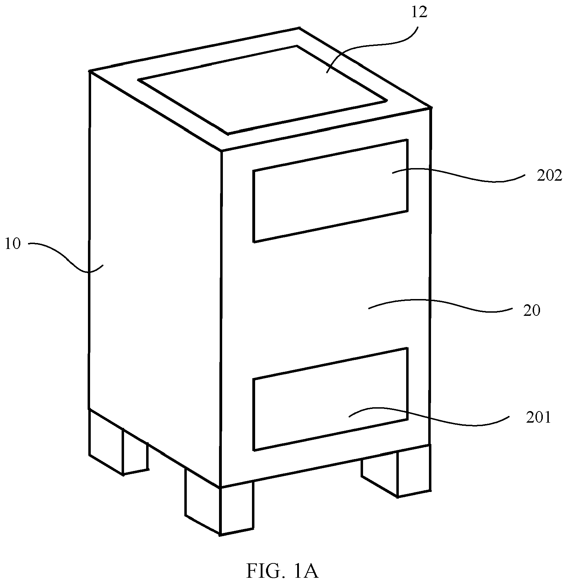

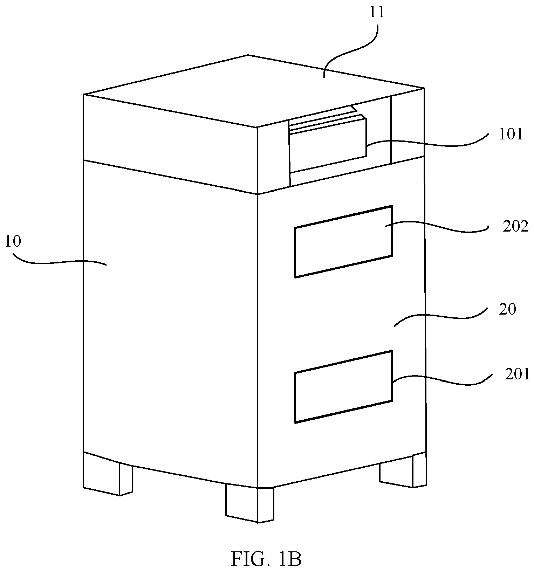

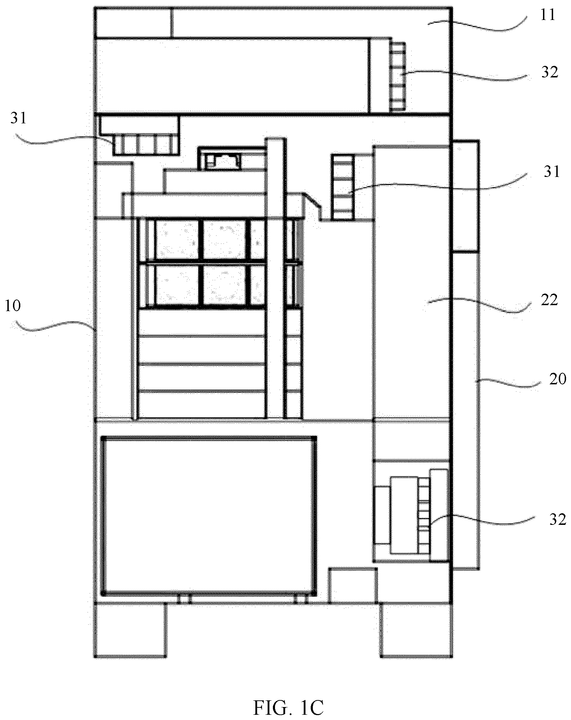

FIG. 1A is a schematic three-dimensional diagram of a cabinet used in the present claimed invention; FIG. 1B is another schematic three-dimensional diagram of a cabinet used in the present claimed invention; FIG. 1C is a schematic structural diagram of a side section of a cabinet according to the present claimed invention;

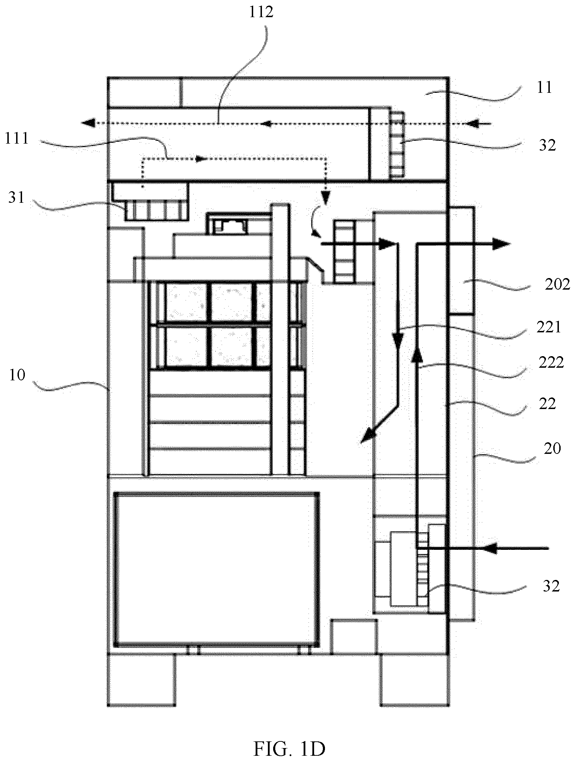

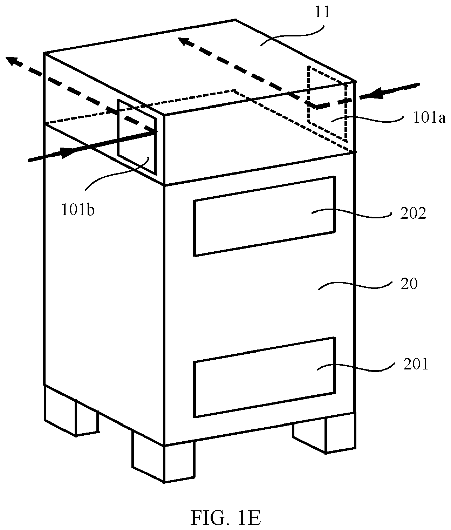

FIG. 1D is a schematic structural diagram of an air flow direction in an internal circulation air duct and an air flow direction in an external circulation air duct in a temperature control component of a cabinet according to the present claimed invention of this application; and FIG. 1E is still another schematic structural diagram of a cabinet used in the present claimed invention of this application.

As described in the background, there is a problem that a temperature control component of an existing outdoor cabinet is wasted and an upgrade requirement of a heat dissipation capability cannot be met. A reason for the problem is as follows: In a door-mounted temperature control form and a top-mounted temperature control form of the existing cabinet, once the heat dissipation capability of the cabinet is insufficient, an original temperature control component can only be removed to free space for replacement with a temperature control component with a larger size and a stronger capability. However, this causes a waste of the temperature control component. In addition, as power of a device in the cabinet increases, the cabinet needs a heat dissipation capability with higher power. However, the cabinet usually has a fixed size and a limited temperature control capability. In other words, even if replacement with the temperature control component with a larger size and a stronger capability is performed, a phenomenon that the heat dissipation capability cannot be met still occurs as power/heat consumption of the internal device of the cabinet continuously increases. Therefore, the heat dissipation capability of the existing cabinet cannot meet the upgrade requirement.

Therefore, to resolve the foregoing problem, as shown in FIG. 1A to FIG. 1E, the cabinet includes a cabinet body. A first-stage temperature control component 11 configured to control a temperature of the cabinet body is disposed on the cabinet body, and at least one temperature control capacity expansion interface 12 that may be used to connect a second-stage temperature control component 22 and the cabinet body is disposed on the cabinet body, so that the second-stage temperature control component 22 is disposed on the cabinet body in an expandable manner. In other words, the first-stage temperature control component 11 is disposed on the cabinet body The first-stage temperature control component 11 may perform one-stage temperature control on the cabinet body. In addition, the temperature control capacity expansion interface 12 is reserved on the cabinet body. In this case, when a heat dissipation capability of the cabinet is insufficient, and in the present claimed invention, the second-stage temperature control component 22 is further directly disposed on the cabinet body through the temperature control capacity expansion interface 12. In this way, the temperature control component on the cabinet is expanded, so that the cabinet is upgraded from the one-stage temperature control to two-stage temperature control. The first-stage temperature control component 11 first cools hot air in the cabinet, and send cold air obtained after cooling to the second-stage temperature control component 22. Air ducts in the two stages of temperature control components form a "serial" relationship, to greatly improve the heat dissipation capability of the cabinet and implement a maximum heat exchange capability of the cabinet. In comparison with the conventional technology, when the heat dissipation capability of the cabinet is insufficient, the first-stage temperature control component 11 does not need to be replaced. Instead, the second-stage temperature control component 22 is directly and disposed in the expandable manner on the cabinet body through the temperature control capacity expansion interface 12, so that the temperature control component on the cabinet can be expanded, thereby avoiding a conventional-technology problem that an original temperature control component is wasted due to replacement with a temperature control component with a larger size and a stronger heat dissipation capability. In addition, the temperature control capacity expansion interface 12 is reserved on the cabinet body. When the heat dissipation capability of the cabinet body is insufficient, the second-stage temperature control component 22 may be directly connected through the reserved temperature control capacity expansion interface 12, so that a temperature control capability of the cabinet is upgraded from the one-stage temperature control to the two-stage temperature control when a size of the cabinet body remains unchanged, to meet the upgrade requirement of the heat dissipation capability of the cabinet. Therefore, the cabinet provided in this application can expand the temperature control component of the cabinet, and upgrade the heat dissipation capability of the cabinet.

When the first-stage temperature control component 11 and the temperature control capacity expansion interface 12 are disposed on the cabinet body, the first-stage temperature control component 11 and the temperature control capacity expansion interface 12 may be disposed on a same face of the cabinet body, or in this embodiment, the first-stage temperature control component 11 and the temperature control capacity expansion interface 12 may be disposed on different faces of the cabinet body. For example, as shown in FIG. 1B, the first-stage temperature control component 11 may be located at a top of the cabinet body, and the temperature control capacity expansion interface 12 may be disposed on a side face of the cabinet body, for example, on a cabinet door 20 of the cabinet body. Alternatively, as shown in FIG. 1A, the temperature control capacity expansion interface 12 is disposed at the top of the cabinet body, and the second temperature control component 22 is located at the top of the cabinet body, and the first-stage temperature control component 11 is disposed on a side face of the cabinet body. It only needs to be ensured that the second-stage temperature control component 22 may be connected to the cabinet body through the reserved temperature control capacity expansion interface 12.

There may be one, two, or more reserved temperature control capacity expansion interfaces 12 on the cabinet body. When there is one temperature control capacity expansion interface 12, the second-stage temperature control component 22 is connected to the temperature control capacity expansion interface 12. When there are two temperature control capacity expansion interfaces 12, the second-stage temperature control component 22 is connected to one temperature control capacity expansion interface 12, and a third-stage temperature control component is connected to the other temperature control capacity expansion interface 12. In this case, three temperature control components are disposed on the cabinet body in the expandable manner, and a temperature control stage of the cabinet body can be upgraded from the one-stage temperature control to three-stage temperature control.

It should be noted that the second-stage temperature control component 22 is usually connected to the temperature control capacity expansion interface 12 when the first-stage temperature control component 11 on the cabinet body cannot meet the heat dissipation capability of the cabinet. Therefore, when the second-stage temperature control component 22 is not connected to the temperature control capacity expansion interface 12, the temperature control capacity expansion interface 12 needs to be in a closed state, to ensure that an interior and an exterior of the cabinet body are disconnected at the temperature control capacity expansion interface 12, thereby preventing an external impurity or dust from entering the cabinet body. When the temperature control component of the cabinet needs to be expanded, the temperature control capacity expansion interface 12 needs to be opened, and the second-stage temperature control component 22 is connected to the temperature control capacity expansion interface 12. The temperature control capacity expansion interface 12 is closed by using the second-stage temperature control component 22. After the second-stage temperature control component 22 is connected to the temperature control capacity expansion interface 12.

Therefore, the cabinet provided in this application includes the cabinet body. The first-stage temperature control component 11 configured to control a temperature of the cabinet body is disposed on the cabinet body, and the at least one temperature control capacity expansion interface 12 that is used to connect the second-stage temperature control component 22 and the cabinet body is disposed on the cabinet body. In this case, when the heat dissipation capability of the cabinet is insufficient, because the temperature control capacity expansion interface 12 is reserved on the cabinet body, the second-stage temperature control component 22 is further directly disposed on the cabinet body through the temperature control capacity expansion interface 12, so that the temperature control component on the cabinet is expanded, and the cabinet is upgraded from the one-stage temperature control to the two-stage temperature control. Under an action of the first-stage temperature control component 11 and the second-stage temperature control component 22, the heat dissipation capability of the cabinet is greatly improved. In comparison with the conventional technology, in this application, when the heat dissipation capability of the cabinet is insufficient, the first-stage temperature control component 11 does not need to be replaced, and the second-stage temperature control component 22 is directly disposed on the cabinet body in the expandable manner through the temperature control capacity expansion interface 12, so that the temperature control component of the cabinet is expanded, thereby avoiding a conventional-technology problem that an original temperature control component is wasted due to replacement with a temperature control component with a larger size and a stronger heat dissipation capability. In addition, in this application, the second-stage temperature control component 22 is connected through the reserved temperature control capacity expansion interface 12, so that the temperature control capability of the cabinet is upgraded from the one-stage temperature control to the two-stage temperature control when a size of the cabinet body remains unchanged, to meet the upgrade requirement of the heat dissipation capability of the cabinet. Therefore, the cabinet provided in this application can expand the temperature control component on the cabinet, upgrade the heat dissipation capability of the cabinet, and resolve an existing problem that the temperature control component is wasted and the heat dissipation capability of the cabinet cannot meet the upgrade requirement due to replacement of the temperature control component when the heat dissipation capability of the cabinet is insufficient.

According to the claimed invention the cabinet further includes the second-stage temperature control component 22. The second-stage temperature control component 22 is disposed on the cabinet body through the temperature control capacity expansion interface 12. Specifically, the second-stage temperature control component 22 may be disposed on the cabinet door 20, and the first-stage temperature control component 11 may be disposed at a top of the cabinet frame 10 (as shown in FIG. 1B and FIG. 1C). Alternatively, the temperature control capacity expansion interface 12 is disposed at the top of the cabinet frame 10 (as shown in FIG. 1A), the second-stage temperature control component 22 is disposed at the top of the cabinet frame 10 through the temperature control capacity expansion interface 12, and the first-stage temperature control component 11 is disposed on the cabinet door 20. In other words, before the heat dissipation capability becomes insufficient, both the first-stage temperature control component 11 and the second-stage temperature control component 22 are arranged on the cabinet body in advance, so that the heat dissipation capability of the cabinet is achieved in one step. In use, when the power and the heat consumption of the device in the cabinet are relatively large, the first-stage temperature control component 11 and the second-stage temperature control component 22 are started simultaneously. In this way, two-stage cooling is performed on the hot air in the cabinet, so that a system heat dissipation capability is greatly improved. When the power and the heat consumption of the device in the cabinet are relatively small, for example, when the power of the internal device of the cabinet is about 1000 W, the heat dissipation requirement can be met by using a heat dissipation capability of one stage of temperature control component. Therefore, only one of the first-stage temperature control component 11 and the second-stage temperature control component 22 needs to be started.

In addition, because the second-stage temperature control component 22 is disposed through the temperature control capacity expansion interface 12, when the heat dissipation capability of the cabinet can meet the requirement by using only one stage of temperature control component, to reduce a weight of the cabinet, the second-stage temperature control component 22 may be removed from the cabinet.

The second-stage temperature control component being disposed on the cabinet frame or the cabinet door, the second-stage temperature control component 22 and the first-stage temperature control component 11 form a circulating cooling air duct in the cabinet body. In other words, , after the second-stage temperature control component 22 is disposed, the second-stage temperature control component 22 and the first-stage temperature control component 11 form the circulating cooling air duct. In this case, during heat dissipation, hot air in the cabinet body passes through the first-stage temperature control component 11 for cooling, and then enter the second-stage temperature control component 22 for cooling. Cold air obtained after cooling through the two stages of temperature control components is blown into the device in the cabinet body for heat dissipation. Finally, hot air obtained after heat dissipation is performed on the device enters the first-stage temperature control component 11 again. In this way, the circulating cooling air duct is formed. In comparison with a cooling air duct formed by disposing the first-stage temperature control component 11 in the cabinet body,according to the claimed invention, the second-stage temperature control component 22 is added to extend the circulating cooling air duct in the cabinet body, so that a cooling path in the cabinet body grows, and the heat dissipation capability of the cabinet is greatly improved.

In a possible implementation, the first-stage temperature control component 11 and the second-stage temperature control component 22 each may be a heat exchanger or an air conditioner. Specifically, a first internal circulation air duct and a first external circulation air duct are disposed in the first-stage temperature control component 11, and a second internal circulation air duct and a second external circulation air duct are disposed in the second-stage temperature control component 22. The first internal circulation air duct and the first external circulation air duct are separated by a heat exchange element in the first-stage temperature control component 11, and the second internal circulation air duct and the second external circulation air duct are separated by a heat exchange element in the second-stage temperature control component 22. An air intake vent and an air exhaust vent of the first internal circulation air duct and an air intake vent and an air exhaust vent of the second internal circulation air duct each communicate with internal space of the cabinet frame 10, and the air exhaust vent of the first internal circulation air duct and the air intake vent of the second internal circulation air duct are disposed opposite to each other, so that cold air obtained after cooling in the first internal circulation air duct enters the second internal circulation air duct for cooling again. Cold air obtained after two-stage cooling is used to perform heat dissipation on the device in the cabinet, and formed hot air enters the first internal circulation air duct again through the air intake vent of the first internal circulation air duct. Finally, the circulating cooling air duct is formed in the cabinet body. In an embodiment the air intake vent 101 of the first external circulation air duct, the air exhaust vent of the first external circulation air duct, the air intake vent 201 of the second external circulation air duct, and the air exhaust vent 202 of the second external circulation air duct each communicate with an exterior of the cabinet body. In an embodiment a working principle of the first-stage temperature control component 11 and the second-stage temperature control component 22 is specifically described by using an example in which the first-stage temperature control component 11 is disposed at the top of the cabinet frame 10 and the second-stage temperature control component 22 is disposed on the cabinet door 20. The working principle is as follows: Hot air in the cabinet enters the first internal circulation air duct through the air intake vent of the first internal circulation air duct, and flows into the cabinet through the air exhaust vent of the first internal circulation air duct after being cooled in the first internal circulation air duct. Cooled air and hot air in the cabinet enter the second internal circulation air duct again through the air intake vent of the second internal circulation air duct, and are discharged into the cabinet through the air exhaust vent of the second internal circulation air duct after being cooled in the second internal circulation air duct. In this way, a temperature is greatly reduced after the hot air is cooled for two times, so that the device in the cabinet can be better cooled. Correspondingly, to exchange heat in the first internal circulation air duct, cold air outside the cabinet enters the first external circulation air duct through the air intake vent 101 of the first external circulation air duct, passes through the first external circulation air duct to carry away the heat, and is discharged to the exterior through the air exhaust vent of the first external circulation air duct. The first external circulation air duct is used to perform a heat exchange on hot air flowing through the first internal circulation air duct, so that the hot air is cooled. Correspondingly, the second external circulation air duct is used to perform a heat exchange on hot air flowing through the second internal circulation air duct, so that the hot air in the second internal circulation air duct is cooled.

In an embodiment, to ensure that cold air in the first external circulation air duct and cold air in the second external circulation air duct respectively perform a relatively good heat dissipation function on the first internal circulation air duct and the second internal circulation air duct, in this embodiment, specifically, as shown in FIG. 1D, the first internal circulation air duct and the first external circulation air duct are two air ducts whose air flow directions are opposite to each other. To be specific, a flow direction 111 of hot air in the first internal circulation air duct and a flow direction 112 of cold air in the first external circulation air duct are opposite to each other. For example, the cabinet door 20 is the front. As shown in FIG. 1D, the flow direction 111 of the hot air in the first internal circulation air duct is rear-in and front-out. To be specific, the air intake vent of the first internal circulation air duct is located on a rear side the cabinet body, and the air exhaust vent of the first internal circulation air duct is located on a front side of the cabinet body. In this case, the flow direction 112 of the cold air in the first external circulation air duct is front-in and rear-out. Alternatively, the flow direction 111 of the hot air in the first internal circulation air duct is left-in and right-out. In this case, the flow direction 112 of the cold air in the first external circulation air duct is right-in and left-out. In other words, the flow direction of the hot air in the first internal circulation air duct is an opposite direction of the flow direction of the cold air in the first external circulation air duct. The internal circulation air duct and the external circulation air duct in the first-stage temperature control component 11 have opposite flow directions. Correspondingly, in this embodiment, the second internal circulation air duct and the second external circulation air duct are two air ducts whose air flow directions are opposite to each other. Specifically, in this embodiment, because the second-stage temperature control component 22 is disposed on the cabinet door 20, the flow direction 221 in the second internal circulation air duct may be top-in and bottom-out, and the flow direction 222 of the cold air in the second external circulation air duct is bottom-in and top-out. Alternatively, in this embodiment, the flow direction 221 in the second internal circulation air duct may be left-in and right-out, and the flow direction 222 of the cold air in the second external circulation air duct is right-in and left-out. It should be noted that, because one side of the cabinet door 20 is usually connected to the cabinet frame 10 in a hinged manner, it is difficult to dispose the air intake vent and the air exhaust vent on left and right sides of the cabinet door 20. Therefore, in this embodiment, when the second internal circulation air duct and the second external circulation air duct are two air ducts whose air flow directions are opposite to each other. Preferably, the flow direction 221 in the second internal circulation air duct is top-in and bottom-out, and the flow direction 222 of the cold air in the second external circulation air duct is bottom-in and top-out (for details, refer to FIG. 3A).

In this embodiment, when the internal circulation air duct and the external circulation air duct in each of the first-stage temperature control component 11 and the internal circulation air duct and the external circulation air duct in the second-stage temperature control component 22 are air ducts opposite to each other, heat exchange efficiency may be relatively high, and it is ensured that the cabinet has a good heat dissipation effect.

In a possible embodiment, as shown in FIG. 1B and FIG. 1C, the cabinet body may include the cabinet frame 10 and the cabinet door 20. The cabinet door 20 is disposed on the cabinet frame 10. Specifically, the cabinet door 20 and the cabinet frame 10 may be connected in the hinged manner. Alternatively, in this embodiment, the cabinet door 20 and the cabinet frame 10 are connected in a sliding manner, or the cabinet door 20 and the cabinet frame 10 are detachably connected in a clamped manner. In this embodiment, a proper connection manner is specifically selected as a connection manner between the cabinet door 20 and the cabinet frame 10 based on an actual requirement. In this embodiment, a connection relationship between the cabinet door 20 and the cabinet frame 10 is not limited.

In this embodiment, when the cabinet body includes the cabinet door 20 and the cabinet frame 10, as shown in FIG. 1B, the first-stage temperature control component 11 may be disposed on the cabinet frame 10, or the first-stage temperature control component 11 may be disposed on the cabinet door 20. Correspondingly, the temperature control capacity expansion interface 12 may be disposed on the cabinet 10, so that the second-stage temperature control component 22 is disposed on the cabinet 10 through the temperature control capacity expansion interface 12, or the temperature control capacity expansion interface 12 may be disposed on the cabinet door 20, so that one stage of temperature control component is disposed on the cabinet door 20 in the expandable manner. In this embodiment, preferably, one of the first-stage temperature control component 11 and the temperature control capacity expansion interface 12 is located on the cabinet frame 10, and the other is located on the cabinet door 20. In this case, the first-stage temperature control component 11 and the second-stage temperature control component 22 are located on different locations on the cabinet body, so that heat dissipation can be performed on different locations on the cabinet body. In addition, when one of the first-stage temperature control component 11 and the second-stage temperature control component 22 is located on the cabinet door 20, the temperature control component faces user space of the cabinet body, thereby ensuring that a key device is in a low-temperature zone. In addition, when the temperature control component is disposed on the cabinet door 20, space inside the cabinet is not occupied, so that utilization of the space inside the cabinet is relatively high.

In this embodiment, in a possible implementation, the first-stage temperature control component 11 is disposed at the top of the cabinet frame 10. In other words, the first-stage temperature control component 11 is disposed at the top of the cabinet frame 10 in advance, so that a temperature control form of the cabinet is a top-mounted temperature control form. In addition, on a basis of top-mounted temperature control, the temperature control capacity expansion interface 12 is reserved on the cabinet door 20, so that the second-stage temperature control component 22 is disposed on the cabinet door 20 in the expandable manner. Finally, the cabinet has the top-mounted temperature control form and a door-mounted temperature control form. In this case, the first-stage temperature control component 11 first performs first-stage cooling on top hot air in the cabinet, and blows cooled air into a front compartment of the cabinet. The second-stage temperature control component 22 is installed on the cabinet door 20 of the cabinet, and sucks first-stage cooled air and some top hot air again to perform second-stage cooling. Finally, air obtained through two-stage cooling is directly sent to each device at a lower part of the cabinet, and two stages of temperature control components implement efficient utilization of space in the cabinet, so that the temperature control capability is greatly improved. Therefore, in this embodiment, in a two-stage temperature control architecture, hot air on different locations in the cabinet can fully exchange heat with the exterior, to implement efficient heat exchange, greatly improve the system heat dissipation capability, and ensure a more proper temperature distribution and well-distributed air ducts inside the cabinet.

In this embodiment, in a possible implementation, the first-stage temperature control component 11 is disposed on the cabinet door 20. In other words, the first-stage temperature control component 11 is arranged on the cabinet door 20 in advance, and the temperature control capacity expansion interface 12 is disposed on a top end face of the cabinet frame 10. When the heat dissipation capability is insufficient, the temperature control component is expanded disposed at the top of the cabinet 10. Specifically, when the second-stage temperature control component 22 is connected to the temperature control capacity expansion interface 12, the temperature control capability of the cabinet is expanded from one-stage temperature control to two-stage temperature control, thereby ensuring that the cabinet can meet a requirement of performing heat dissipation on internal devices of different power. In this embodiment, through verification, when the first-stage temperature control component 11 is disposed on the cabinet door 20, the system heat dissipation capability is 1500 W. When the second-stage temperature control component 22 is disposed at the top of the cabinet 10 in the expandable manner, the system heat dissipation capability of the cabinet is improved to 2500 W or even 3500 W. In this way, when the internal device of the cabinet gradually develops from 1000 W in 2G and 3G to more than 2000 W, the heat dissipation capability of the cabinet provided in this embodiment can still meet a requirement of performing heat dissipation on the internal device in the cabinet.

In this embodiment, in a possible implementation, the cabinet further includes a cover (not shown). The cover is configured to cover the temperature control capacity expansion interface 12 when the second-stage temperature control component 22 is not connected to the temperature control capacity expansion interface 12, so that the temperature control capacity expansion interface 12 is in the closed state. In other words, when the second-stage temperature control component 22 is not connected to the temperature control capacity expansion interface 12 on the cabinet body, the temperature control capacity expansion interface 12 is closed by using the cover. When the heat dissipation capability of the cabinet is insufficient, the cover is removed, and the second-stage temperature control component 22 is connected to the temperature control capacity expansion interface 12. In this case, the first-stage temperature control component 11 and the second-stage temperature control component 22 are connected to the cabinet body, so that the heat dissipation capability of the cabinet body is greatly improved.

In this embodiment, in a possible implementation, specifically, when the first-stage temperature control component 11 is disposed at the top of the cabinet 10 and the second-stage temperature control component 22 is disposed on the cabinet door 20, the air exhaust vent of the first internal circulation air duct may be disposed close to the cabinet door 20, and the air intake vent of the first internal circulation air duct is disposed close to the rear side wall of the cabinet frame 10. In other words, the hot air in the first internal circulation air duct is rear-in and front-out, and the air intake vent of the second internal circulation air duct is disposed close to the air exhaust vent of the first internal circulation air duct. To be specific, the air intake vent of the second internal circulation air duct is located at an upper part of the cabinet door 20, and the air exhaust vent of the second internal circulation air duct is disposed close to a bottom of the cabinet door 20. In this case, the hot air in the cabinet moves to the top of the cabinet, enters the first internal circulation air duct through the air intake vent of the first internal circulation air duct, is blown towards the cabinet door 20 after cooling, enters the second internal circulation air duct through the air intake vent of the second internal circulation air duct on the cabinet door 20, and is discharged through the air exhaust vent of the second internal circulation air duct at the bottom end of the cabinet door 20 after cooling, to cool the device located at the lower part of the cabinet, and ensure that the lower part of the cabinet has a minimum temperature. According to the claimed invention the first internal circulation air duct and the second internal circulation air duct form a "serial" relationship, to form an air flow that flows in a clockwise direction in the cabinet, so that heat exchange efficiency becomes higher. When the flow direction in the first internal circulation air duct is rear-in and front-out, because a flow direction of cold air in the first external circulation air duct is opposite to a flow direction of hot air in the first internal circulation air duct, as shown in FIG. 1B, the air intake vent 101 of the first external circulation air duct may be located on a front side face of the first-stage temperature control component 11, and the air exhaust vent is located on a rear face of the first-stage temperature control component 11, or the air intake vent 101 of the first external circulation air duct may be located in the front of a top face of the first-stage temperature control component 11, and the air exhaust vent of the first external circulation air duct is located in the rear of the top face of the first-stage temperature control component 11. In other words, the air exhaust vent and the air intake vent of the first external circulation air duct are disposed on the side face or the top face of the first-stage temperature control component 11, and the air intake vent and the air exhaust vent of the second external circulation air duct are disposed on the cabinet door 20. The air intake vent and the air exhaust vent of the second external circulation air duct are specifically disposed on locations corresponding to locations on which the air intake vent and the air exhaust vent of the first internal circulation are located on the cabinet door 20. a possible implementation, the first-stage temperature control component 11 is disposed at the top of the cabinet frame 10, the second-stage temperature control component 22 is disposed on the cabinet door 20, and the first external circulation air duct in the first-stage temperature control component 11 may have one air intake vent 101 (as shown in FIG. 1B), or the first external circulation air duct may have a plurality of air intake vents 101. In addition, the plurality of air intake vents 101 of the first external circulation air duct are respectively located on a side face and/or a top face of the first temperature control component 11. In other words, the plurality of air intake vents 101 may be located on the side face of the first temperature control component 11, or may be located on the top face of the first temperature control component 11. Alternatively, one air intake vent 101 is located on the top face of the first temperature control component 11, and the other air intake vents 101 may be located on the side face of the first temperature control component 11. The second external circulation air duct in the second temperature control component 22 may have one or more air intake vents.

Specifically, in an embodiment, referring to FIG. 1E, the first temperature control component 11 is disposed at the top of the cabinet body, and the first external circulation air duct in the first temperature control component 11 has two air intake vents 101 that are respectively an air intake vent 101a and an air intake vent 101b, and the air intake vent 101a and the air intake vent 101b of the first external circulation air duct are respectively located on a left side face and a right side face of the first temperature control component 11. In this case, air may simultaneously enter the first external circulation air duct through both the air intake vent 101a and the air intake vent 101b on the two side faces of the first temperature control component 11, so that an intake air volume of the first external circulation air duct is greatly increased, and a cooling effect of the first temperature control component 11 is greatly improved. In this embodiment, when the air intake vent 101a and the air intake vent 101b are disposed on the first temperature control component 11, one or two air exhaust vents may be disposed on the rear side face or the top face of the first temperature control component 11. In this case, the air flow direction 111 in the first internal circulation air duct may be rear-in and front-out, and is opposite to the air flow direction 112 in the first external circulation air duct. In this embodiment, to further enlarge the air intake vent, three air intake vents of the first external circulation air duct may be disposed. In this case, the air intake vent 101a and the air intake vent 101b may be disposed on left and right sides of the first temperature control component 11, and the third air intake vent is disposed on the top face of the first temperature control component 11. In this case, air may simultaneously enter the first external circulation air duct through all of the three air intake vents, so that a heat dissipation rate of the first temperature control component 11 becomes faster.

In this embodiment, when the first temperature control component 11 is disposed at the top of the cabinet frame and the second temperature control component 22 is disposed on the cabinet door 20, the air exhaust vent 202 of the second external circulation air duct in the second temperature control component 22 is usually located on the upper part of the cabinet door 20. In this case, if the air intake vent of the first external circulation air duct is disposed on the front side face of the first temperature control component 11, hot air discharged from the air exhaust vent 202 of the second external circulation air duct easily enters the first external circulation air duct through the air intake vent 101 of the first external circulation air duct. In this case, it is not conducive for the first external circulation air duct to cool the hot air in the first internal circulation air duct. To prevent the hot air discharged from the air exhaust vent 202 of the second external circulation air duct from flowing back to the first external circulation air duct, in this embodiment, preferably, the air intake vent 101 of the first external circulation air duct is disposed on the left and right side faces, the rear side face, or the top face of the first temperature control component 11, and is prevented from being disposed on the front side face that is of the first temperature control component 11 and that is located on a same side as the cabinet door 20. In this case, the air intake vent 101 of the first external circulation air duct may be far away from the air exhaust vent 202 of the second external circulation air duct, to prevent the hot air from flowing back.

In this embodiment, the air exhaust vent and the air intake vent of the first internal circulation air duct may be separately disposed close to two opposite internal side walls of the cabinet frame 10. For example, the air exhaust vent of the first internal circulation air duct is disposed close to a left internal side wall of the cabinet frame 10, and the air intake vent of the first internal circulation air duct is disposed close to a right internal side wall of the cabinet frame 10. In other words, the flow direction of the hot air in the first internal circulation air duct is right-in and left-out, and is a left-right flow direction. In this case, the air exhaust vent of the first external circulation air duct is disposed close to the right internal side wall of the cabinet 10, the air intake vent of the first external circulation air duct is disposed close to the left internal side wall of the cabinet 10, and a flow direction in the first external circulation air duct is left-in and right-out. According to the claimed invention the air intake vent of the second internal circulation air duct is disposed close to the air exhaust vent of the first internal circulation air duct. For example, the air intake vent of the second internal circulation air duct is located on a left upper part or a right upper part of the cabinet door 20, and the air exhaust vent of the second internal circulation air duct is disposed at an end that is of the cabinet door 20 and that is away from the air intake vent of the second internal circulation air duct, for example, may be located on a right lower part or a left lower part of the cabinet door 20.

According to the claimed invention an internal circulation fan 31 is disposed at each of the air intake vent of the first internal circulation air duct and the air intake vent of the second internal circulation air duct, and an external circulation fan 32 is disposed at each of the air intake vent of the first external circulation air duct and the air intake vent of the second external circulation air duct. In this case, the hot air in the cabinet is sucked into an internal circulation air duct through the air intake vent of the first internal circulation air duct and the air intake vent of the second internal circulation air duct under an action of the internal circulation fan 31 for cooling. The cold air outside the cabinet is sucked into an external circulation air duct through the air intake vent of the second external circulation air duct and the air intake vent of the second external circulation air duct under an action of the external circulation fan 32 for a heat exchange. A flow rate of the hot air inside the cabinet and a flow rate of the cold air outside the cabinet are accelerated by using the internal and external circulation fans 32. This improves heat dissipation efficiency of the cabinet.

In , a possible implementation, the cabinet may be an outdoor cabinet, for example, may be an outdoor power supply cabinet, or an outdoor equipment cabinet. Alternatively, the cabinet may be an indoor cabinet, for example, may be an indoor equipment cabinet or an indoor power supply cabinet. It should be noted that, in this embodiment, the cabinet includes but is not limited to a power supply cabinet and an equipment cabinet, or may be another cabinet.

In a possible implementation, the first-stage temperature control component 11 and the second-stage temperature control component 22 are temperature control components including one or more of a heat exchanger, an air conditioner, and a semiconductor refrigeration air conditioner. In other words, the first-stage temperature control component 11 and the second-stage temperature control component 22 may be heat exchangers. Alternatively, the first-stage temperature control component 11 and the second-stage temperature control component 22 may be temperature control components including both a heat exchanger and an air conditioner. In this embodiment, temperature control components selected as the first-stage temperature control component 11 and the second-stage temperature control component 22 may be the same or different. For example, the first-stage temperature control component 11 is a heat exchanger, and the second-stage temperature control component 22 is an air conditioner. In a possible implementation, the cabinet further includes a noise reduction component. The noise reduction component is disposed on the second-stage temperature control component 22. In this case, when the second-stage temperature control component 22 is added to an outdoor structure, system noise of the cabinet does not exceed a limit easily by using the noise reduction component.

### Embodiment 2, not in accordance with the claimed invention J

FIG. 2 is a schematic structural diagram of an air flow direction in an internal circulation air duct and an air flow direction in an external circulation air duct in a temperature control component in a main view of a cabinet according to Embodiment 2 of this application.

In this embodiment, as shown in FIG. 2, an example in which a first-stage temperature control component 11 is disposed at a top of a cabinet 10, and a second-stage temperature control component 22 is disposed on a cabinet door 20 is specifically used for description. Specifically, in this embodiment, a first internal circulation air duct and a first external circulation air duct are two air ducts whose air flow directions intersect. In other words, a flow direction 111 of hot air in the first internal circulation air duct and a flow direction 112 of cold air in the first external circulation air duct intersect. For example, the cabinet door 20 is the front. In this case, the flow direction 111 of the hot air in the first internal circulation air duct may be rear-in and front-out, and the flow direction 112 of the cold air in the first external circulation air duct is left-in and right-out, or right-in and left-out. Alternatively, the flow direction 111 of the hot air in the first internal circulation air duct is left-in and right-out, and the flow direction 112 of the cold air in the first external circulation air duct is front-in and rear-out, or rear-in and front-out. In other words, the flow direction 111 of the hot air in the first internal circulation air duct and the flow direction 112 of the cold air in the first external circulation air duct intersect, and flow directions in the internal and external circulation air ducts of the first-stage temperature control component 11 intersect. Correspondingly, a second internal circulation air duct and a second external circulation air duct are two air ducts whose air flow directions intersect. Specifically, in this embodiment, because the second-stage temperature control component 22 is disposed on the cabinet door 20, a flow direction 221 in the second internal circulation air duct may be top-in and bottom-out, and a flow direction 222 of cold air in the second external circulation air duct is left-in and right-out, or right-in and left-out. In other words, an air intake vent of the second external circulation air duct is located on a left side of the cabinet door 20, and an air exhaust vent is located on a right side of the cabinet door 20. Alternatively, the air intake vent of the second external circulation air duct is located on the right side of the cabinet door 20, and the air exhaust vent of the second external circulation air duct is located on the left side of the cabinet door 20. Alternatively, in this embodiment, the flow direction in the second internal circulation air duct may be left-in and right-out, and the flow direction of the cold air in the second external circulation air duct is bottom-in and top-out, or top-in and bottom-out.

### Embodiment 3, not in accordance with the claimed invention

FIG. 3A is a schematic structural diagram of an air flow direction in an internal circulation air duct and an air flow direction in an external circulation air duct in a temperature control component in a main view of a cabinet according to Embodiment 3 of this application; FIG. 3B is another schematic structural diagram of an air flow direction in an internal circulation air duct and an air flow direction in an external circulation air duct in a temperature control component in a main view of a cabinet according to Embodiment 3 of this application; and FIG. 3C is still another schematic structural diagram of an air flow direction in an internal circulation air duct and an air flow direction in an external circulation air duct in a temperature control component in a main view of a cabinet according to Embodiment 3 of this application.

A difference between the cabinet provided in this embodiment and the cabinet in the foregoing embodiments is as follows: In this embodiment, as shown in FIG. 3C, a first internal circulation air duct and a first external circulation air duct are two air ducts whose air flow directions are opposite to each other, and a second internal circulation air duct and a second external circulation air duct are two air ducts whose air flow directions intersect. Alternatively, as shown in FIG. 3A and FIG. 3B, the first internal circulation air duct and the first external circulation air duct are two air ducts whose air flow directions intersect, and the second internal circulation air duct and the second external circulation air duct are two air ducts whose air flow directions are opposite to each other. In other words, air flow directions in one internal circulation air duct and one external circulation air duct in the first-stage temperature control component 11 and the second-stage temperature control component 22 are opposite to each other, and an air flow direction in the other internal circulation air duct and an air flow direction in the other external circulation air duct intersect. For example, when a first-stage temperature control component 11 is disposed at a top of a cabinet frame 10, and a second-stage temperature control component 22 is disposed on a cabinet door 20, the first internal circulation air duct and the first external circulation air duct intersect, and the second internal circulation air duct and the second external circulation air duct are opposite each other. For example, the first internal circulation air duct is a rear-in and front-out air duct, namely, a front-back air duct, and the first external circulation air duct is a left-in and right-out air duct, or a right-in and left-out air duct, namely, a left-right air duct. The second internal circulation air duct is a top-in and bottom-out air duct, namely, a top-bottom air duct, and the second external circulation air duct is a bottom-in and top-out air duct, and is opposite to the second internal circulation air duct. In this embodiment, the first-stage temperature control component 11 may alternatively be disposed on the cabinet door 20, and the second-stage temperature control component 22 is disposed at the top of the cabinet 10. In this case, an internal circulation air duct and an external circulation air duct in the first-stage temperature control component 11 may be top-bottom air ducts that are opposite to each other, and an internal circulation air duct and an external circulation air duct in the second-stage temperature control component 22 are respectively a front-rear air duct and a left-right air duct that intersect. In the description of the present invention, it should be noted that, unless otherwise expressly specified and limited, the terms "mount", "connect", and "connection" should be understood broadly. For example, there may be a fixed connection, may be an indirect connection performed through an intermediate medium, or may be an internal connection between two elements or an interaction relationship between two elements. For a person of ordinary skill in the art, specific meanings of the foregoing terms in the present invention may be understood based on a specific situation.

In descriptions of the present invention, it should be understood that, a direction or location relationships indicated by terms such as "up", "down", "front", "rear", "vertical", "horizontal", "top", "bottom", "interior", and "exterior" are based on direction or location relationships shown by the accompanying drawings, are only used for describing the present invention and for description simplicity, but do not indicate or imply that an indicated apparatus or element needs to have a specific orientation or needs to be constructed and operated in a specific orientation. Therefore, this cannot be understood as a limitation on the present invention. In the descriptions of the present invention, "a plurality of" means two or more, unless specifically specified otherwise.

In the specification, claims, and accompanying drawings of this application, the terms "first", "second", "third", "fourth", and so on (if existent) are intended to distinguish between similar objects but do not necessarily indicate a specific order or sequence. It should be understood that the data termed in such a way are interchangeable in proper circumstances so that the embodiments of this application described herein can be implemented in orders except the order illustrated or described herein. Moreover, the terms "include", "contain" and any other variants mean to cover the non-exclusive inclusion, for example, a process, method, system, product, or device that includes a list of steps or units is not necessarily limited to those units, but may include other units not expressly listed or inherent to such a process, method, system, product, or device.

Finally, it should be noted that the foregoing embodiments are merely intended for describing the technical solutions of the present invention, but not for limiting the present invention. Although the present invention is described in detail with reference to the foregoing embodiments, persons of ordinary skill in the art should understand that they may still make modifications to the technical solutions described in the foregoing embodiments or make equivalent replacements to some or all technical features thereof, without departing from the scope of the present invention, which is defined by the appended claims.

## Claims

1. A cabinet, comprising:
a cabinet body, wherein a first-stage temperature control component (11) configured to control a temperature of the cabinet body is disposed on the cabinet body, and at least one temperature control capacity expansion interface that may be used to connect a second-stage temperature control component (22) and the cabinet body, is disposed on the cabinet body, so that the second-stage temperature control component (22) is disposed on the cabinet body in an expandable manner, and the second-stage temperature control component (22) and the first-stage temperature control component (11) form a circulating cooling air duct in the cabinet body, so that hot air in the cabinet body passes through the first-stage temperature control component (11) for cooling, and then enters the second-stage temperature control component (22) for cooling;
wherein the cabinet further comprises the second-stage temperature control component (22), wherein the second-stage temperature control component (22) is disposed on the cabinet body through the temperature control capacity expansion interface;
wherein a first internal circulation air duct and a first external circulation air duct are disposed in the first-stage temperature control component (11), a second internal circulation air duct and a second external circulation air duct are disposed in the second-stage temperature control component (22), an air intake vent and an air exhaust vent of the first internal circulation air duct and an air intake vent and an air exhaust vent of the second internal circulation air duct each communicate with internal space in the cabinet body, and the air exhaust vent of the first internal circulation air duct and the air intake vent of the second internal circulation air duct are disposed opposite to each other, so that cold air obtained after cooling in the first internal circulation air duct enters the second internal circulation air duct for cooling again;
wherein an internal circulation fan (31) is disposed at each of the air intake vent of the first internal circulation air duct and the air intake vent of the second internal circulation air duct, such that the hot air in the cabinet is sucked into an internal circulation air duct through the air intake vent of the first internal circulation air duct and the air intake vent of the second internal circulation air duct under an action of the internal circulation fan for cooling.

2. The cabinet according to claim 1, wherein an air intake vent and an air exhaust vent of the first external circulation air duct and an air intake vent (201) and an air exhaust vent (202) of the second external circulation air duct each communicate with an exterior of the cabinet body.

3. The cabinet according to claim 2, wherein the first internal circulation air duct and the first external circulation air duct are two air ducts whose air flow directions are opposite to each other, and the second internal circulation air duct and the second external circulation air duct are two air ducts whose air flow directions are opposite to each other.

4. The cabinet according to any one of claims 2 to 3, wherein the cabinet body comprises a cabinet frame (10) and a cabinet door, the first-stage temperature control component (11) is disposed on the cabinet frame (10) or the cabinet door, and the temperature control capacity expansion interface is disposed on the cabinet frame (10) or the cabinet door

5. The cabinet according to claim 4, wherein the first-stage temperature control component (11) is disposed at a top of the cabinet frame (10), and the temperature control capacity expansion interface is disposed on the cabinet door, so that the second-stage temperature control component (22) is disposed on the cabinet door in the expandable manner.

6. The cabinet according to claim 4, wherein the first-stage temperature control component (11) is disposed on the cabinet door, and the temperature control capacity expansion interface is disposed on a top end face of the cabinet frame (10), so that the second-stage temperature control component (22) is disposed on the cabinet frame (10) in the expandable manner.

7. The cabinet according to any one of claims 4 to 6, wherein the first-stage temperature control component (11) is disposed at the top of the cabinet frame (10), the second-stage temperature control component (22) is disposed on the cabinet door, the air exhaust vent of the first internal circulation air duct is disposed close to the cabinet door, the air intake vent of the first internal circulation air duct is disposed close to a rear side wall of the cabinet frame (10), the air intake vent of the second internal circulation air duct is disposed close to the air exhaust vent of the first internal circulation air duct, and the air exhaust vent of the second internal circulation air duct is disposed close to a bottom end of the cabinet door; or
the air exhaust vent and the air intake vent of the first internal circulation air duct are respectively disposed close to two opposite internal side walls in the cabinet frame (10), the air intake vent of the second internal circulation air duct is disposed close to the air exhaust vent of the first internal circulation air duct, and the air exhaust vent of the second internal circulation air duct is disposed at an end that is of the cabinet door and that is away from the air intake vent of the second internal circulation air duct.

8. The cabinet according to any one of claims 4 to 6, wherein the first-stage temperature control component (11) is disposed at the top of the cabinet frame (10), the second-stage temperature control component (22) is disposed on the cabinet door, the air exhaust vent and the air intake vent of the first external circulation air duct are disposed on a side face or a top face of the first-stage temperature control component (11), and the air intake vent (201) and the air exhaust vent (202) of the second external circulation air duct are disposed on the cabinet door

9. The cabinet according to any one of claims 4 to 6, wherein the first-stage temperature control component (11) is disposed at the top of the cabinet frame (10), the second-stage temperature control component (22) is disposed on the cabinet door, the first external circulation air duct in the first-stage temperature control component (11) has one or more air intake vents, and a plurality of air intake vents of the first external circulation air duct are respectively located on a side face and/or a top face of the first-stage temperature control component (11).

10. The cabinet according to any one of claims 2 to 9, wherein an external circulation fan (32) is disposed at each of the air intake vent of the first external circulation air duct and the air intake vent of the second external circulation air duct.

11. The cabinet according to any one of claims 1 to 10, further comprising a cover, wherein the cover is configured to cover the temperature control capacity expansion interface when the second-stage temperature control component (22) is not connected to the temperature control capacity expansion interface, so that the temperature control capacity expansion interface is in a closed state.

12. The cabinet according to any one of claims 1 to 11, wherein the cabinet is an outdoor cabinet or an indoor cabinet.

## Patentansprüche

1. Schrank, Folgendes umfassend:
einen Schrankkörper, wobei eine Temperatursteuerungskomponente erster Stufe (11), die dazu ausgelegt ist, die Temperatur des Schrankkörpers zu steuern, am Schrankkörper angeordnet ist, und mindestens eine Temperatursteuerungskapazitätserweiterungsschnittstelle, die dazu verwendet werden kann, eine Temperatursteuerungskomponente zweiter Stufe (22) und den Schrankkörper miteinander zu verbinden, am Schrankkörper angeordnet ist, sodass die Temperatursteuerungskomponente zweiter Stufe (22) erweiterbar am Schrankkörper angeordnet ist, und wobei die Temperatursteuerungskomponente zweiter Stufe (22) und die Temperatursteuerungskomponente erster Stufe (11) einen Kühlungsluftkreislaufkanal im Schrankkörper ausbilden, sodass heiße Luft im Schrankkörper zum Kühlen durch die Temperatursteuerungskomponente erster Stufe (11) verläuft und anschließend zum Kühlen in die Temperatursteuerungskomponente zweiter Stufe (22) eintritt;
wobei der Schrank ferner die Temperatursteuerungskomponente zweiter Stufe (22) umfasst, wobei die Temperatursteuerungskomponente zweiter Stufe (22) durch die Temperatursteuerungskapazitätserweiterungsschnittstelle am Schrankkörper angeordnet ist,
wobei ein erster innerer Luftzirkulationskanal und ein erster äußerer Luftzirkulationskanal in der Temperatursteuerungskomponente erster Stufe (11) angeordnet sind, ein zweiter innerer Luftzirkulationskanal und ein zweiter äußerer Luftzirkulationskanal in der Temperatursteuerungskomponente zweiter Stufe (22) angeordnet sind, eine Lufteinlassöffnung und eine Luftauslassöffnung des ersten inneren Luftzirkulationskanals und eine Lufteinlassöffnung und eine Luftauslassöffnung des zweiten inneren Luftzirkulationskanals jeweils mit dem Innenraum des Schrankkörpers kommunizieren und die Luftauslassöffnung des ersten inneren Luftzirkulationskanals und die Lufteinlassöffnung des zweiten inneren Luftzirkulationskanals einander entgegengesetzt angeordnet sind, sodass nach dem Kühlen im ersten inneren Luftzirkulationskanal erhaltene kalte Luft für erneutes Kühlen in den zweiten inneren Luftzirkulationskanal eintritt;
wobei ein inneres Umluftgebläse (31) jeweils an der Lufteinlassöffnung des ersten inneren Luftzirkulationskanals und der Lufteinlassöffnung des zweiten inneren Luftzirkulationskanals angeordnet ist, sodass die heiße Luft im Schrank unter der Wirkung des inneren Umluftgebläses zum Kühlen durch die Lufteinlassöffnung des ersten inneren Luftzirkulationskanals und die Lufteinlassöffnung des zweiten inneren Luftzirkulationskanals in einen inneren Luftzirkulationskanal gesaugt wird.

2. Schrank nach Anspruch 1, wobei eine Lufteinlassöffnung und eine Luftauslassöffnung des ersten äußeren Luftzirkulationskanals und eine Lufteinlassöffnung (201) und eine Luftauslassöffnung (202) des zweiten äußeren Luftzirkulationskanals jeweils mit dem Äußeren des Schrankkörpers kommunizieren.

3. Schrank nach Anspruch 2, wobei der erste innere Luftzirkulationskanal und der erste äußere Luftzirkulationskanal zwei Luftkanäle sind, deren Luftströmungsrichtungen einander entgegengesetzt sind, und wobei der zweite innere Luftzirkulationskanal und der zweite äußere Luftzirkulationskanal zwei Luftkanäle sind, deren Luftströmungsrichtungen einander entgegengesetzt sind.

4. Schrank nach einem der Ansprüche 2 bis 3, wobei der Schrankkörper ein Schrankgestell (10) und eine Schranktür umfasst, wobei die Temperatursteuerungskomponente erster Stufe (11) am Schrankgestell (10) oder an der Schranktür angeordnet ist und wobei die Temperatursteuerungskapazitätserweiterungsschnittstelle am Schrankgestell (10) oder an der Schranktür angeordnet ist.

5. Schrank nach Anspruch 4, wobei die Temperatursteuerungskomponente erster Stufe (11) auf der Oberseite des Schrankgestells (10) angeordnet ist und die Temperatursteuerungskapazitätserweiterungsschnittstelle an der Schranktür angeordnet ist, sodass die Temperatursteuerungskomponente zweiter Stufe (22) erweiterbar an der Schranktür angeordnet ist.

6. Schrank nach Anspruch 4, wobei die Temperatursteuerungskomponente erster Stufe (11) an der Schranktür angeordnet ist und die Temperatursteuerungskapazitätserweiterungsschnittstelle auf der oberen Stirnseite des Schrankgestells (10) angeordnet ist, sodass die Temperatursteuerungskomponente zweiter Stufe (22) erweiterbar am Schrankgestell (10) angeordnet ist.

7. Schrank nach einem der Ansprüche 4 bis 6, wobei die Temperatursteuerungskomponente erster Stufe (11) auf der Oberseite des Schrankgestells (10) angeordnet ist, die Temperatursteuerungskomponente zweiter Stufe (22) an der Schranktür angeordnet ist, die Luftauslassöffnung des ersten inneren Luftzirkulationskanals in der Nähe der Schranktür angeordnet ist, die Lufteinlassöffnung des ersten inneren Luftzirkulationskanals in der Nähe der Rückseitenwand des Schrankgestells (10) angeordnet ist, die Lufteinlassöffnung des zweiten inneren Luftzirkulationskanals in der Nähe der Luftauslassöffnung des ersten inneren Luftzirkulationskanals angeordnet ist und die Luftauslassöffnung des zweiten inneren Luftzirkulationskanals in der Nähe des unteren Endes der Schranktür angeordnet ist, oder
die Luftauslassöffnung und die Lufteinlassöffnung des ersten inneren Luftzirkulationskanals jeweils in der Nähe zweier entgegengesetzter innerer Seitenwände des Schrankgestells (10) angeordnet sind, die Lufteinlassöffnung des zweiten inneren Luftzirkulationskanals in der Nähe der Luftauslassöffnung des ersten inneren Luftzirkulationskanals angeordnet ist und die Luftauslassöffnung des zweiten inneren Luftzirkulationskanals an einem Ende der Schranktür angeordnet ist, das von der Lufteinlassöffnung des zweiten inneren Luftzirkulationskanals beabstandet ist.

8. Schrank nach einem der Ansprüche 4 bis 6, wobei die Temperatursteuerungskomponente erster Stufe (11) auf der Oberseite des Schrankgestells (10) angeordnet ist, die Temperatursteuerungskomponente zweiter Stufe (22) an der Schranktür angeordnet ist, die Luftauslassöffnung und die Lufteinlassöffnung des ersten äußeren Luftzirkulationskanals an einer Seitenfläche oder der Oberseite der Temperatursteuerungskomponente erster Stufe (11) angeordnet sind und die Lufteinlassöffnung (201) und die Luftauslassöffnung (202) des zweiten äußeren Luftzirkulationskanals an der Schranktür angeordnet sind.

9. Schrank nach einem der Ansprüche 4 bis 6, wobei die Temperatursteuerungskomponente erster Stufe (11) auf der Oberseite des Schrankgestells (10) angeordnet ist, die Temperatursteuerungskomponente zweiter Stufe (22) an der Schranktür angeordnet ist, der erste äußere Luftzirkulationskanal in der Temperatursteuerungskomponente erster Stufe (11) eine oder mehrere Lufteinlassöffnungen aufweist und mehrere Lufteinlassöffnungen des ersten äußeren Luftzirkulationskanals jeweils auf einer Seitenfläche und/oder einer Oberseite der Temperatursteuerungskomponente erster Stufe (11) angeordnet sind.

10. Schrank nach einem der Ansprüche 2 bis 9, wobei ein äußeres Umluftgebläse (32) jeweils an der Lufteinlassöffnung des ersten äußeren Luftzirkulationskanals und an der Lufteinlassöffnung des zweiten äußeren Luftzirkulationskanals angeordnet ist.

11. Schrank nach einem der Ansprüche 1 bis 10, ferner umfassend eine Abdeckung, wobei die Abdeckung dazu ausgelegt ist, die Temperatursteuerungskapazitätserweiterungsschnittstelle abzudecken, wenn die Temperatursteuerungskomponente zweiter Stufe (22) nicht mit der Temperatursteuerungskapazitätserweiterungsschnittstelle verbunden ist, sodass sich die Temperatursteuerungskapazitätserweiterungsschnittstelle in einem geschlossenen Zustand befindet.

12. Schrank nach einem der Ansprüche 1 bis 11, wobei der Schrank ein Schrank für den Außenbereich oder für den Innenbereich ist.

## Revendications

1. Armoire, comprenant :
un corps d'armoire, dans laquelle un composant de commande de température de première phase (11) configuré pour commander une température du corps d'armoire est disposé sur le corps d'armoire, et au moins une interface d'accroissement de capacité de commande de température qui peut être utilisée pour connecter un composant de commande de température de seconde phase (22) et le corps d'armoire, est disposée sur le corps d'armoire, pour que le composant de commande de température de seconde phase (22) soit disposé sur le corps d'armoire de manière pouvant être accrue, et le composant de commande de température de seconde phase (22) et le composant de commande de température de première phase (11) forment un conduit d'air de refroidissement de circulation dans le corps d'armoire, pour que de l'air chaud dans le corps d'armoire passe à travers le composant de commande de température de première phase (11) pour le refroidissement, puis entre dans le composant de commande de température de seconde phase (22) pour le refroidissement ;
dans laquelle l'armoire comprend en outre le composant de commande de température de seconde phase (22), dans laquelle le composant de commande de température de seconde phase (22) est disposé sur le corps d'armoire par l'intermédiaire de l'interface d'accroissement de capacité de commande de température ;
dans laquelle un premier conduit d'air de circulation interne et un premier conduit d'air de circulation externe sont disposés dans le composant de commande de température de première phase (11), un second conduit d'air de circulation interne et un second conduit d'air de circulation externe sont disposés dans le composant de commande de température de seconde phase (22), un évent d'admission d'air et un évent d'évacuation d'air du premier conduit d'air de circulation interne et un évent d'admission d'air et un évent d'évacuation d'air du second conduit d'air de circulation interne communiquent chacun avec un espace interne dans le corps d'armoire, et l'évent d'évacuation d'air du premier conduit d'air de circulation interne et l'évent d'admission d'air du second conduit d'air de circulation interne sont disposés de façon opposée l'un à l'autre, pour que de l'air froid obtenu après le refroidissement dans le premier conduit d'air de circulation interne entre dans le second conduit d'air de circulation interne pour le refroidissement à nouveau ;
dans laquelle un ventilateur de circulation interne (31) est disposé au niveau de chacun de l'évent d'admission d'air du premier conduit d'air de circulation interne et de l'évent d'admission d'air du second conduit d'air de circulation interne, de telle sorte que l'air chaud dans l'armoire soit aspiré dans un conduit d'air de circulation interne à travers l'évent d'admission d'air du premier conduit d'air de circulation interne et l'évent d'admission d'air du second conduit d'air de circulation interne sous une action du ventilateur de circulation interne pour le refroidissement.

2. Armoire selon la revendication 1, dans laquelle un évent d'admission d'air et un évent d'évacuation d'air du premier conduit d'air de circulation externe et un évent d'admission d'air (201) et un évent d'évacuation d'air (202) du second conduit d'air de circulation externe communiquent chacun avec un extérieur du corps d'armoire.

3. Armoire selon la revendication 2, dans laquelle le premier conduit d'air de circulation interne et le premier conduit d'air de circulation externe sont deux conduits d'air dont les directions d'écoulement d'air sont opposées l'une à l'autre, et le second conduit d'air de circulation interne et le second conduit d'air de circulation externe sont deux conduits d'air dont les directions d'écoulement d'air sont opposées l'une à l'autre.

4. Armoire selon l'une quelconque des revendications 2 et 3, dans laquelle le corps d'armoire comprend un cadre d'armoire (10) et une porte d'armoire, le composant de commande de température de première phase (11) est disposé sur le cadre d'armoire (10) ou la porte d'armoire, et l'interface d'accroissement de capacité de commande de température est disposée sur le cadre d'armoire (10) ou la porte d'armoire.

5. Armoire selon la revendication 4, dans laquelle le composant de commande de température de première phase (11) est disposé sur un haut du cadre d'armoire (10), et l'interface d'accroissement de capacité de commande de température est disposée sur la porte d'armoire, pour que le composant de commande de température de seconde phase (22) soit disposé sur la porte d'armoire de la manière pouvant être accrue.

6. Armoire selon la revendication 4, dans laquelle le composant de commande de température de première phase (11) est disposé sur la porte d'armoire, et l'interface d'accroissement de capacité de commande de température est disposée sur une face d'extrémité supérieure du cadre d'armoire (10), pour que le composant de commande de température de seconde phase (22) soit disposé sur le cadre d'armoire (10) de la manière pouvant être accrue.

7. Armoire selon l'une quelconque des revendications 4 à 6, dans laquelle le composant de commande de température de première phase (11) est disposé sur le haut du cadre d'armoire (10), le composant de commande de température de seconde phase (22) est disposé sur la porte d'armoire, l'évent d'évacuation d'air du premier conduit d'air de circulation interne est disposé près de la porte d'armoire, l'évent d'admission d'air du premier conduit d'air de circulation interne est disposé près d'une paroi latérale arrière du cadre d'armoire (10), l'évent d'admission d'air du second conduit d'air de circulation interne est disposé près de l'évent d'évacuation d'air du premier conduit d'air de circulation interne, et l'évent d'évacuation d'air du second conduit d'air de circulation interne est disposé près d'une extrémité inférieure de la porte d'armoire ; ou
l'évent d'évacuation d'air et l'évent d'admission d'air du premier conduit d'air de circulation interne sont respectivement disposés près de deux parois latérales internes opposées dans le cadre d'armoire (10), l'évent d'admission d'air du second conduit d'air de circulation interne est disposé près de l'évent d'évacuation d'air du premier conduit d'air de circulation interne, et l'évent d'évacuation d'air du second conduit d'air de circulation interne est disposé à une extrémité qui est de la porte d'armoire et qui est éloignée de l'évent d'admission d'air du second conduit d'air de circulation interne.

8. Armoire selon l'une quelconque des revendications 4 à 6, dans laquelle le composant de commande de température de première phase (11) est disposé sur le haut du cadre d'armoire (10), le composant de commande de température de seconde phase (22) est disposé sur la porte d'armoire, l'évent d'évacuation d'air et l'évent d'admission d'air du premier conduit d'air de circulation externe sont disposés sur une face latérale ou une face supérieure du composant de commande de température de première phase (11), et l'évent d'admission d'air (201) et l'évent d'évacuation d'air (202) du second conduit d'air de circulation externe sont disposés sur la porte d'armoire.

9. Armoire selon l'une quelconque des revendications 4 à 6, dans laquelle le composant de commande de température de première phase (11) est disposé sur le haut du cadre d'armoire (10), le composant de commande de température de seconde phase (22) est disposé sur la porte d'armoire, le premier conduit d'air de circulation externe dans le composant de commande de température de première phase (11) a un ou plusieurs évents d'admission d'air, et une pluralité d'évents d'admission d'air du premier conduit d'air de circulation externe sont respectivement situés sur une face latérale et/ou une face supérieure du composant de commande de température de première phase (11).

10. Armoire selon l'une quelconque des revendications 2 à 9, dans laquelle un ventilateur de circulation externe (32) est disposé au niveau de chacun de l'évent d'admission d'air du premier conduit d'air de circulation externe et de l'évent d'admission d'air du second conduit d'air de circulation externe.

11. Armoire selon l'une quelconque des revendications 1 à 10, comprenant en outre un couvercle, dans laquelle le couvercle est configuré pour couvrir l'interface d'accroissement de capacité de commande de température lorsque le composant de commande de température de seconde phase (22) n'est pas connecté à l'interface d'accroissement de capacité de commande de température, pour que l'interface d'accroissement de capacité de commande de température soit dans un état fermé.

12. Armoire selon l'une quelconque des revendications 1 à 11, dans laquelle l'armoire est une armoire extérieure ou une armoire intérieure.
